# EUROPEAN PATENT APPLICATION

(11) **EP 4 489 176 A2**
(43) Date of publication of application: **08.01.2025**
(21) Application number: 23187565.9
(22) Date of filing: 25.07.2023
(51) Int. Cl.: H01M 10/42, H01M 10/48, B60L 3/12, G01R 31/392

(54) **EXTERNAL SENSING FOR MONITORING HEALTH OF VEHICLE ELECTRIC ENERGY STORAGE**

(30) Priority: 27.06.2023 US 202318342618
(71) Applicant: Aptiv Technologies AG, 8200 Schaffhausen (CH)
(72) Inventor: Coon, Bradley Scott, Russiaville, IN, 46979 (US); Imboden, David Jerold, Kokomo, IN, 46902 (US)
(74) Representative: Manitz Finsterwald Patent- und Rechtsanwaltspartnerschaft mbB

(57) **Abstract**

This document describes external sensing for passively monitoring health of vehicle electric energy storage. Techniques for relying on measurements reported from sensors arranged external to an energy storage device (ESD) are described. Overall health of the ESD is inferred without relying on charging circuits or self-diagnosing on the ESD. External measurements (e.g., capacitive, inductance, temperature) are used to identify potential physical deformations or other signs of physical failure of an ESD. These measurements provide early warnings of impending ESD failure. Other ESD monitors may fail to detect these conditions and/ or be too slow to prevent damage from thermal runaways or other catastrophic failures when they occur. A described unintrusive ESD health monitoring is described to enhance ESD safety; dangerous surface temperatures, physical swelling, or other unsafe conditions are detected early to intervene and cease operations before it is too late.

## Description

### BACKGROUND

Electrical and computing systems are ubiquitous parts of most vehicles (e.g., cars, trucks) used to enable vehicle operations related to driving. Vehicle systems often derive electrical power from different types of on-board, energy storage devices (ESDs). With a few exceptions, many ESDs are not easily swappable and only replaced under controlled conditions under the supervision of trained technicians. Rechargeable ESD technology is popular on vehicles because their computer systems can recharge the ESDs to replenish vehicle energy stores via an interface to onboard or external charging systems. Driving environments are harsh on vehicle ESD technology; extreme temperatures and high output requirements can induce early wear or physical damage. Individual cells of an unhealthy electric vehicle (EV) battery pack, or simply referred to as a vehicle battery, may swell, especially under use when charging or satisfying demand for a vehicle load. For instance, during high operating temperatures, thermal runaway may occur. A build-up of internal gas (e.g., outgassing) causes an increase in the physical size of the cell and surrounding parts of the battery pack. Over time, frequent swelling may reduce operating life and/or storage capacity. Too much swelling at once can cause a catastrophic ESD failure on a vehicle, which may release hazardous and flammable gases that risk injuring people and damaging property.

### SUMMARY

This document describes external sensing for monitoring the health of vehicle electric energy storage. Techniques for relying on measurements reported from sensors arranged external to an energy storage device (ESD) are described. Overall health of the ESD is inferred without relying on charging circuits or self-diagnosing performed on the vehicle or by the ESD. External measurements (e.g., capacitive, inductance, temperature) are used to identify potential physical deformations or other signs of physical failure of an ESD. These measurements provide early warnings of impending ESD failure. Other ESD monitors may fail to detect these conditions or may be too slow to prevent damage from thermal runaways or other catastrophic failures when they are likely to occur. An unintrusive ESD health monitoring is described to enhance ESD safety; dangerous surface temperatures, physical swelling, or other unsafe conditions are detected early to intervene and cease operations with the ESD before it is too late.

For example, swelling or enlargement in an ESD often results in a variable distance between a top and bottom exterior surface surrounding an ESD cell of a battery pack, which is encased in a protective shrink wrap or other enclosure with other ESD cells. When the distance between the two surfaces vary too much to cause a physical deformation in size of the ESD, a corresponding inconsistent capacitance or inductance can be detected from a sensor positioned near the deformation (or at edges of the deformation). Sensor data received from sensors arranged in positions adjacent to surfaces of the ESD can detect a variation in their measured capacitance or inductance, which is indicative of a physical expansion or deformation of that part of the ESD and be an early indicator of ESD failure or performance deterioration. The external ESD measurements can be captured using a simple sensor arrangement that is external to individual cells of the ESD, which can provide a highly reliable and accurate detector of unsafe operating conditions involving one or multiple cells of the ESD.

In response to detecting unexpected changes in capacitance, inductance, or other sensor measurement relative to the ESD exterior, a notification may be output to alert the vehicle 102 and/or occupants about a potential deformed and/or unhealthy ESD. A vehicle processor may trigger a warning or automatically intervene to cause a charging session or other use of the ESD to be terminated. Rather than trusting an ESD self-diagnosis or other ESD monitoring circuits that focus on health power flow into and out of the ESD, the described techniques enable other types of safety monitoring, including monitoring for battery swelling and other dangers to ESD health, which safeguards people and their vehicles in more situations where these other systems cannot.

This document also describes methods performed by the above-summarized system and other configurations set forth herein and computer-executable instructions and means for performing these methods.

This Summary introduces simplified concepts related to external sensing for monitoring health of vehicle electric energy storage in the Detailed Description and Drawings. This Summary is not intended to identify essential features of the claimed subject matter, nor to determine the scope of the claimed subject matter.

### BRIEF DESCRIPTION OF THE DRAWINGS

The details of one or more aspects of systems and techniques for external sensing for monitoring health of vehicle electric energy storage are described in this document with reference to the following figures. The same numbers are often used throughout the drawings to reference like features and components:
FIG. 1 illustrates an example environment in which external sensing for monitoring health of vehicle electric energy storage may be employed in accordance with techniques of this disclosure;
FIG. 2 illustrates an example configuration of a vehicle system for external sensing for monitoring health of vehicle electric energy storage;
FIG. 3 illustrates an example configuration of a battery system that is integrated with an example external sensing system for monitoring health of vehicle electric energy storage;
FIGS. 4-1 and 4-2 illustrate additional details of an external sensing system integrated with a vehicle electric energy storage system;
FIGS. 5-1 through 5-4 illustrate an example vehicle situation in which external sensing is used for monitoring health of vehicle electric energy storage in accordance with techniques of this disclosure;
FIGS. 6-1 and 6-2 illustrate an example flow chart for monitoring health of vehicle electric energy storage; and
FIG. 7 illustrates an example process for monitoring health of vehicle electric energy storage.

### DETAILED DESCRIPTION

### OVERVIEW

As described above, computing systems and electrical systems are ubiquitous parts of most vehicles (e.g., cars, trucks), which often rely on electrical power from on-board energy and energy storage devices (ESD). To minimize having to replace individual batteries, rechargeable batteries and ESD technology can be used on printed circuit boards, such as, to enable persistent storage for memory to a system on chip (SoC). An ESD can supply energy to drive a propulsion system, vehicle heating and cooling system, or other electrical system. High-voltage (e.g., 240V, 300V) electrical vehicle (EV) battery packs and their low-voltage (e.g., 12V, 24V) counterparts are further examples of ESD technology that is predisposed to physical deterioration when used in a vehicle environment.

With a few exceptions, many vehicle ESDs are not designed to be swappable by untrained technicians. Instead, they are composed of rechargeable ESD technology, which can be replenished from a computer controlled charging session with an on-board and/or external charging circuit. Some rechargeable batteries or other ESD technology developed for vehicles is predisposed to swelling. This can cause physical deformation of the device itself, especially when driving or charging in high temperature environments. For example, driving environments are harsh on vehicle ESD technology; extreme temperatures and high output requirements can induce early wear or even physical damage. Just one or a few bad cells of an EV battery pack may swell during high temperatures due to thermal runaway, where a build-up of internal gas (e.g., outgassing) causes an increase in physical size. The outgassing may be caused by various factors, including poor manufacturing, manufacturing defects in the battery cells, overcharging, deep discharging, physical damage, or exposure to excessively high temperature fluctuations, or natural aging. At worst, swelling may reduce operating life and/or storage capacity over time. Too much swelling can cause a catastrophic ESD failure on a vehicle, which may release hazardous and even flammable gases that risk injuring people and damaging property.

Existing systems do not consider external factors indicative of deteriorating battery health, such as physical signs of swelling, to identifying portions where the ESD may be damaged because of outgassing. Some wired and/or wireless vehicle ESD charging systems may include diagnostics based on temperature, voltage, current, or humidity sensors. However, these charging systems do not monitor for potential battery deformation let alone detect the deformation and report the risk of catastrophic failure from continued operations. Because the warning systems that existing ESD chargers provide are incomplete, vehicles and occupants are often unaware of potential risks during what may otherwise seem like a typical, safe vehicle charging or driving situation.

In contrast, this document describes techniques and systems involving external sensing for monitoring health of vehicle electric energy storage. For example, swelling or enlargement in an ESD often results in a variable distance between a top and bottom exterior surface surrounding an ESD cell of a battery pack, which is encased in a protective shrink wrap or other enclosure with other ESD cells. When the distance between the two surfaces vary too much to cause a physical deformation in size of the ESD, a corresponding inconsistent capacitance or inductance can be detected from data received from sensors arranged adjacent to one or both surfaces. Variation from a nominal measured capacitance or inductance from a sensor arrangement placed near, or across different cells, can indicate an unhealthy ESD. The techniques may be used to monitor deformation of individual cells or damage to a battery pack wrap. An example system can capture these external ESD measurements using a simple sensor arrangement that can easily be integrated in an existing vehicle structure used to support the ESD. For example, external monitors are positioned about ESD enclosures and/or embedded in panels (e.g., cooling plates) near individual or pairs of pouches / battery cells to passively measure for changes in capacitance, inductance, or other measurable inconsistencies across different sensors placed near different exterior regions of the ESD.

These changes indicate potential failure conditions and represent potential risks to personal and vehicle safety. To provide a highly reliable and accurate detector of unsafe operating conditions involving the ESD and/or the vehicle infrastructure, any unexpected changes in external sensor measurements are evaluated for possible reporting to vehicle systems (e.g., to trigger an interruption to charging operations or other vehicle functions using the ESD under load. An example system includes a processor that detects when a vehicle ESD is being charged or used to supply a vehicle load. During the charging or operational session involving use of the ESD, the processor obtains external-sensor values from multiple external sensors integrated on the vehicle or in and around exterior locations near exterior regions of the ESD where physical deformations from outgassing may occur. The processor analyzes the capacitance, the inductance, and/or other sensor values and determines whether they deviate from nominal or calibrated values. When the sensor data deviates from a stored ESD profile, an alert may be output indicating a potential deformation of the rechargeable ESD or ESD cell, which may be caused by swelling or other damage. In response to detecting unexpected changes in capacitance, inductance, or temperature between the ESD and one or more of the external ESD sensors, the processor may output a notification of a potential deformed and unhealthy ESD to cause a charging session or other use of the ESD to be terminated.

Vehicles may automatically slowly wind down or discontinue their ESD operations and rely on back-up or hydraulic/mechanical systems for power until the vehicles can be stopped at a safe location (e.g., away from other vehicles and people, in a repair garage). Rather than trusting an ESD self-diagnosis or other ESD monitoring circuit, the described techniques enable more accurate monitoring and earlier warnings of battery swelling and other dangers to ESD health, which safeguards people and their vehicles in more situations where other systems cannot. In this way, the described techniques involving external sensing for monitoring health of vehicle electric energy storage can improve ESD operational safety, and potentially avoid dangers and catastrophic failures if the unsafe conditions were otherwise allowed to progress further before being noticed by an onboard alarm or occupant.

These examples are just some examples of the described techniques and systems for external sensing for monitoring health of vehicle electric energy storage. This document describes many other examples and implementations, which can be readily combined in different ways to accommodate a particular vehicle application.

### OPERATING ENVIRONMENT

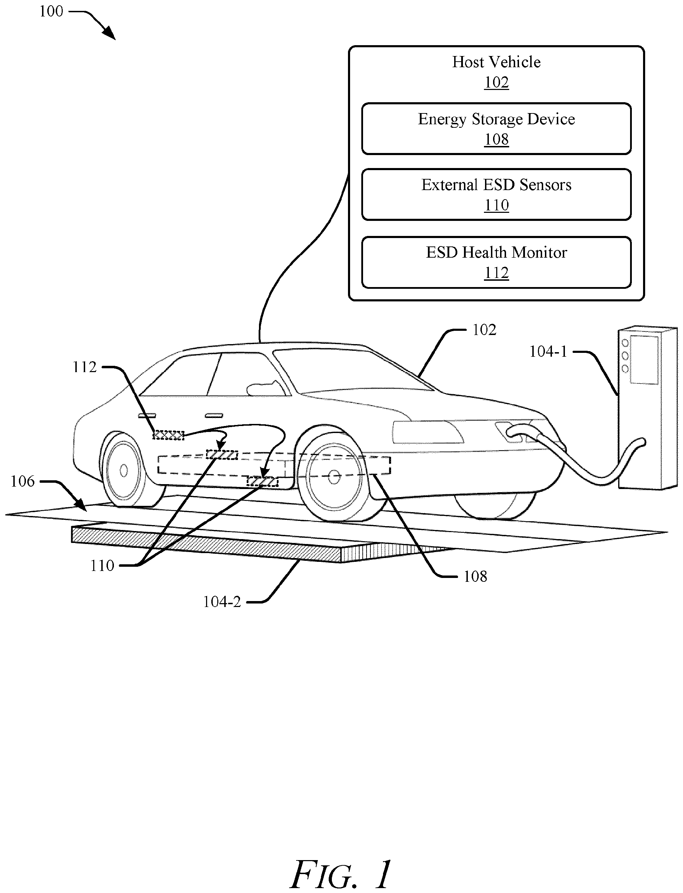

FIG. 1 illustrates an example environment 100 in which external sensing for monitoring health of vehicle electric energy storage may be employed in accordance with techniques of this disclosure. The environment 100 is illustrated near a charging station 104, however, the environment 100 can also include any other operating environment for a host vehicle 102, which relies on an energy storage device (ESD) 108, including in situations where the ESD is used to supply electrical power to one or more vehicle loads.

The vehicle 102 is resting on a ground surface 106 near a wired charging station 104-1 or a wireless charging station 104-2 to replenish the ESD 108 with power supplied from a grid or other electrical source providing energy to the charging station 104. After recharging the ESD 108, the host vehicle 102 may be idling or pulling away from the charging station 104; the ESD 108 may switch from operating in charging mode to operating as an energy source for electric propulsion and/or for supplying other vehicle loads (e.g., a vehicle electrical system).

The host vehicle 102 may be a motorized vehicle (e.g., a car, an automobile, a motorcycle, a passenger truck, a bus, a tractor, a semi-trailer truck), a watercraft (e.g., a boat), or an aircraft (e.g., an airplane) that includes the ESD 108, in addition to one or more external ESD sensors 110 and an ESD Health Monitor 112. In other implementations, the external ESD sensors 110 and/or the ESD Health Monitor 112 may be integrated within the charging station 104 itself. For example, the charging station 104 may or other external device may have capability to externally monitor health of the ESD 108 during an ongoing charging session, from detecting changes in physical size of different regions (e.g., different cells) of the ESD 108 relative their nominal size relative other parts of the vehicle 102.

The ESD 108 may be a rechargeable ESD, such as a rechargeable battery. For example, the ESD 108 may be a high voltage battery pack comprising a plurality of individual (e.g., Lithium-ion) battery cells. The ESD 108 may be another storage device in the host vehicle 102 (e.g., a battery associated with an airbag system, a vehicle starter battery, a circuit board ESD). The terms "battery", "energy storage device", and "ESD" may be used interchangeably in this document to refer to one or more electrochemical cells and other energy storage devices configured to provide electrical energy to a connected energy resource or load during discharge and accept and store electrical energy during charging from an energy source. The ESD 108 represents a rechargeable ESD that may be used in many personal, commercial, and automotive applications. These examples of the ESD 108 are available in various sizes and chemistries including, for example, Zinc-Carbon, Alkaline, Lead Acid, Nickel Cadmium, Nickel-Zinc, Nickel Metal Hydride, and Lithium-Ion. In addition, batteries usually must perform in a variety of conditions, including severe environments (e.g., with extreme temperatures); common applications for the ESD 108 include embedded computers, embedded devices, communication radios, data processing circuits, and hybrid-electric or all-electric vehicle systems.

The vehicle 102 includes multiple external ESD sensors 110 arranged outside the ESD 108 to obtain physical measurements of the ESD 108 from detecting changes in electrical characteristics of the ESD 108, relative various sensors that are fixed relative the vehicle 102. When the measurements deviate from nominal or previously stored values indicating good health, the measurements indicate the ESD 108 is deteriorating or in an unhealthy state for continued use.

The ESD sensors 110 may be multiple capacitive sensors positioned near one side (e.g., a top, a bottom) of the ESD 108 to measure capacitance between that side of the ESD 108 and the nearby sensor. When deformation occurs, a dielectric constant of a medium (e.g., air) between the sensor and the ESD 108 changes; a distance between the ESD 108 and the sensor decreases due to an expansion in the size of a unit cell in the ESD 108. The ESD sensors 110 may include multiple inductive sensors configured to measure changes in inductance relative to the vehicle 102 and different exterior regions of the ESD 108. The ESD sensors 110 may include multiple pressure sensors (e.g., other types of sensors) configured to detect compression in the material of the ESD sensors 110 that is above the sensor pads.

The ESD sensors 110 generate sensor data used to compare against nominal data, for monitoring the ESD 108 for deteriorating health conditions, which may go undetected by other onboard charging or battery management systems. The sensor data may include capacitance values obtained from capacitive sensors, inductance values obtained from inductance sensors, or other sensor data. The ESD sensors 110 are configured to report sensor data that can be compared against thresholds associated with nominal measurements, to determine whether a poor health condition exists, which may be undetectable from built-in monitoring circuitry of the ESD 108, the vehicle 102, and/or the charging station 104.

Although illustrated for ease of drawing as having just two ESD sensors 110, the ESD sensors 110 can include an arrangement of many sensors including a combination of different sensor types. The ESD sensors 110 are carefully positioned at specific locations in the vehicle 102, relative to the ESD 108 and its mounting position within the vehicle 102. The ESD sensors 110 may be arranged in a horizontal array, a vertical array, or a combination thereof, including attached near the ESD 108 or placed on an outer surface of the ESD 108 (e.g., a protective layer, a shrink wrap, a housing).

The ESD health monitor 112 reads or obtains measurements from the ESD sensors 110. Based on the measurements, the ESD monitor 112 determines whether the capacitance, inductance, temperature, or other sensor values (or changes in the values over time) indicates a physical deformation of the ESD 108. For example, when the vehicle 102 is connected to the wired charging stations 104-1 or parked over the wireless charging station 104-1, the ESD sensor measurements (e.g., capacitance) are generally consistent or near uniform across the ESD 108 because the ESD 108 has a uniform flatness near locations of the vehicle 102 where the ESD sensors 110 are attached. The typical measurements expected for the ESD 108 may be stored between vehicle power cycles in a persistent memory (e.g., as saved ESD profiles).

The sensor measurements for each sensor and for each different ESD on the vehicle 102 may have a calibrated or previously stored (e.g., typical, steady-state) value indicative of the ESD 108 being in good health (e.g., without any physical deformation). However, if the ESD 108 is deformed, its shape results in a less uniform size or dimension, variation in the sensor measurements can occur. For example, much higher capacitance measurements may be received from the ESD sensors 110 that are located under or near a deformation in the packaging or housing of the ESD 108, which is caused by outgassing. Air has a much lower dielectric constant than plastic, causing capacitance, inductance, or other ESD sensor measurements resulting from less dielectric separation, including plastic-air-plastic, between a portion of the ESD 108 and the ESD sensors 110 to be measurably different (e.g., higher). Lower value sensor measurements result from a thicker dielectric separation (e.g., plastic-on-plastic stack), which allows more air or dielectric to be between the ESD sensors 110 and the exterior of the ESD 108. With high voltage EV battery systems, other materials besides plastic are often used to support internal components of the ESD 108. For example, aluminum coated plastic, carbon fiber, or other materials may provide structure to the ESD 108, and also allow variation in the ESD sensor measurements when the ESD 108 deforms. As described in greater detail below, the inference of the physical deformation based on results from the ESD sensors 110 may be determined from a decreasing air gap or dielectric layer formed between the surfaces of the ESD 108 that are expanding at or around the ESD sensors 110. The ESD 108 may physically deform on the exterior to cause a compression of the ESD sensors 110 (e.g., their substrate layer). The compression causes a variation in the measurements from their corresponding sensor pads relative to the measurements output prior to the compression. When the ESD sensors 110 and supporting structure are compressed under the force of the bulging ESD 108, the sensor measurements deviate from nominal values. When the measurements veer too far from the steady state values originally established when no deformation occurs, the ESD health monitor 112 determines that the ESD 108 may have a physical deformation, which is a sign of deteriorating health.

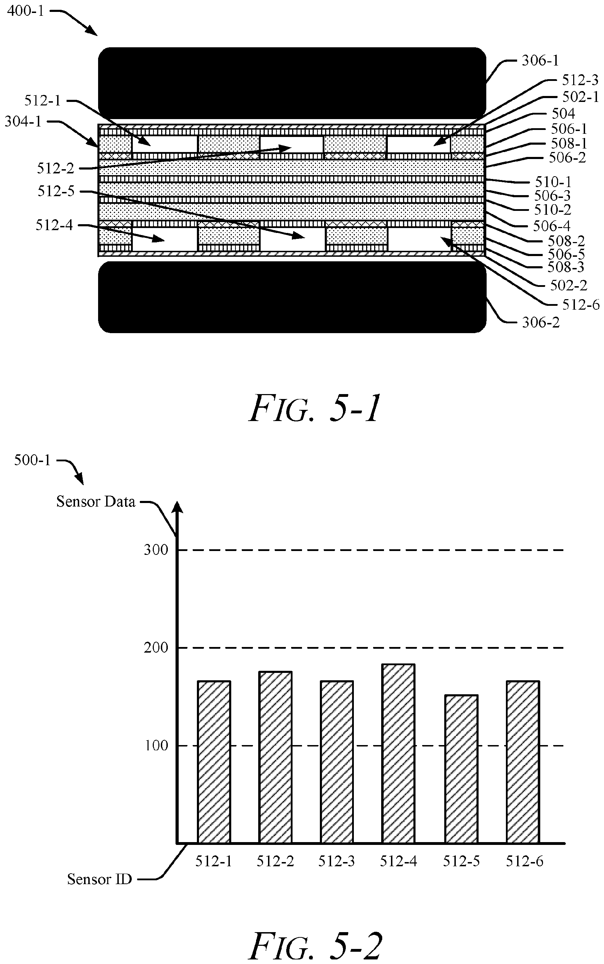

The external ESD sensors 110 represent a sensor circuit for monitoring health of an energy storage device installed in a vehicle. As explained in greater detail below, the ESD sensors 110 (e.g., the sensor circuit) may include multiple layers of stacked material arranged fixed near an exterior surface of the energy storage device (e.g., the ESD 108). For example, as shown in FIG. 5-1, the multiple layers can include at least one sensor layer to support individual sensor pads for a plurality of embedded sensors, in addition to at least one substrate layer to isolate and maintain the individual sensor pads supported by the sensor layer at a nominal distance from the exterior surface of the ESD 108. In addition, the multiple layers can include at least one signal layer operatively coupled to the individual sensor pads to output measurements from the sensor pad of each of the embedded sensors among the ESD sensors 110.

The ESD health monitor 112 may include one or multiple processors, processing circuits, processing modules, microcontrollers, or other component configured to perform operations for monitoring the health of the ESD 108 using the sensor circuit provided with the ESD sensors 110. For example, at least one processor may be operable with the sensor circuit to execute functions of the ESD health monitor 112, which include determining, based on the measurements from the ESD sensors 110, whether any of their corresponding sensor pads is closer to the exterior surface of the ESD 108 than the nominal distance maintained by the substrate layer.

In some cases, the detection of a deformation or compression that causes the measurements to deviate results in an output a warning about a potential failure of the ESD 108. That is, an alarm or warning may be output to recommend or discontinue use of the ESD 108 in response to determining that the measurements from at least one sensor pad of the ESD sensors 110 indicates a deformation in the ESD 108, which is detectable from a compression caused in the substrate layer that moves the exterior surface of the ESD 108 to be in closer proximity to at least one sensor pad than the nominal distance (or previous measurement).

### VEHICLE CONFIGURATION

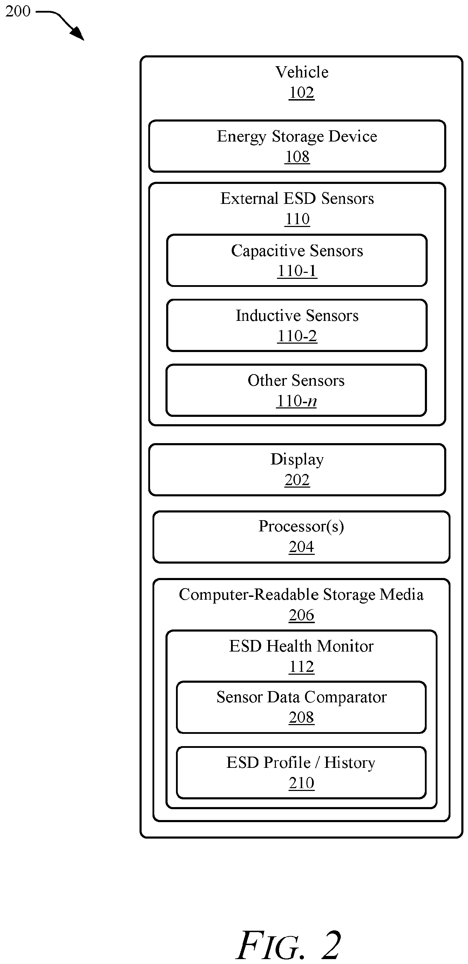

FIG. 2 illustrates an example configuration 200 of a vehicle system for external sensing for monitoring health of vehicle electric energy storage. The vehicle system provided in the configuration 200 includes the host vehicle 102 shown equipped with the ESD 108, the ESD sensors 110, and the ESD health monitor 112. These elements, and the additional elements shown in FIG. 2, are described in the context of FIG. 1.

As discussed above when monitoring health of an ESD, a physical deformation is one indicator of a compromised or failing ESD. In this state, when an ESD is in poor health and failing, initiating a charging session to recharge one or more bad cells of the ESD can cause a critical failure, which damages property or even causes injury.

To help ensure that the ESD is not compromised and safe to use in charging or other vehicle operations, the vehicle 102 relies on information provided from the ESD health monitor 112. The ESD health monitor 112 processes sensor data obtained from the ESD sensors 110 to monitor external measurements of the ESD 108, which based on the arrangement of the ESD sensors 110 about different parts of the ESD 108, are indicators of poor or satisfactory ESD health.

For example, the host vehicle 102 includes a display 202, one or more processors 204, and computer-readable storage media (CRM) 206. The display 202 may be integrated into a center console or dashboard of the host vehicle 102. For example, the display 202 outputs graphical information to provide the driver or a passenger with the status of the ESD 108 during a charging session or when utilizing the ESD 108 when operating under vehicle load. The processors 204 (e.g., energy processing units, electronic control units, or microcontrollers) may be a microprocessor or a system-on-chip. The processors 204 execute instructions stored in the CRM 206, on one or more disks, memories, or other non-transitory computer-readable storage media.

The ESD health monitor 112 may include executable instructions and data stored on the CRM 206. The processors 204 may retrieve the instructions from the CRM 206 to cause functions of the ESD health monitor 112 to be performed on the vehicle 102. For example, the processors 204 process measurement values from the ESD sensors 110 and execute instructions loaded from the CRM 206 that cause the processors 204 to monitor the capacitance, inductance, temperature, or other external sensor values associated with the ESD 108 and determine whether physical deformation occurs. In executing the ESD health monitor 112, the processors 204 are configured to monitor and report (e.g., via the display, to other vehicle systems) about situations when the ESD 108 is potentially failing. For example, the ESD health monitor 112 may cause the processors 204 to output a notification to various systems on the vehicle 102 to warn when a critical physical ESD deformation is detected. The display 202 may be configured to output a visual warning about the ESD health.

In executing the ESD health monitor 112, the processors 204 may notify the driver that a previous charging error was detected for the ESD 108 and ask the user whether to initiate or continue the current charging session. For example, the ESD health monitor 112 causes a graphical user interface on the display 202 to indicate warnings about overall ESD health to a driver or occupant of the vehicle 102. User input may be required at the user interface (e.g., including an authorization code from a technician or external device) to manually prevent the ESD 108 from being charged or used even though it may be failing. The health notifications output from the ESD health monitor 112 may be transmitted to other components on the vehicle 102 to take appropriate actions to further safe operations with the vehicle 102. For example, one or more communication devices of the vehicle 102 may enable a sensor interface between the external ESD sensors 110 and the processors 204, in addition to a vehicle interface between the processors 204 used to execute the ESD health monitor 112, and other components on the vehicle 102.

Data about ESD health and measurements taken by the external ESD sensors 110 may pass through the sensor interface and the vehicle interface to effect safe vehicle operations. ESD health monitoring data, including charging errors and driver inputs (e.g., overrides) may be transmitted throughout the vehicle components over a wired or wireless link, which may further exchange data between the vehicle 102 and a remote system (e.g., a mobile phone, a remote server). The vehicle 102 may include communication hardware, software, and/or firmware required to communicate information over Wi-Fi^{®}, using local area networks (LANs), using dedicated short-Range communication (e.g., Bluetooth^{®}, infrared), employing Vehicle-to-Everything (V2X) communication, communicating on a vehicle communication bus, or transmitting and receiving over cellular connections.

The ESD health monitor 112 may include a sensor data comparator 208 and also may maintain a saved ESD profile / history 210. The sensor data comparator 208 periodically or occasionally analyzes measurement values from the external ESD sensors 110 to determine whether ESD deformation occurred. In other words, over time, the sensor data comparator 208 compares the measurements output to a signal layer configured to propagate measurements from the ESD sensors 110 to the processors 204. Based on the measurements output over time, whether any of the sensor pads of the ESD sensors 110 is closer to the exterior surface of the ESD 108 than the nominal distance maintained by a substrate layer is determined. As described below, a battery deformation (e.g., a vehicle battery deformation) or other ESD irregularity may be indicated by a large variance or standard deviation in the measured values relative to a profile or history of measurements maintained for the ESD 108.

With access to the ESD provide / history 210, the ESD health monitor 112 can log or index the measurement values for individual ESDs (e.g., the ESD 108 among other ESDs on the vehicle 102) to assist in the analysis performed by the sensor data comparator 208. The ESD profile / history 210 can be stored in the CRM 206 or another CRM. The ESD profile / history 210 may also maintain a record of previous charging errors for a particular ESD so that the ESD health monitor 112 can provide an indication or alert to the user on the display 202 to ask for user input prior to initiating or continuing operating with that ESD. For example, predetermined thresholds, previous measured averages, or individual measured values are stored in the ESD profile / history 210. The saved profiles 210 may also include default profiles for popular models and types of ESDs to assist in detecting battery deformation during a first charging session for a particular ESD in the vehicle 102. The saved profiles 210 may also include a knowledge of the age of each index or entry therein, which may be continually updated with new entries throughout the ESD's life. In some examples, other sensors (e.g., thermal, moisture, humidity, pressure) can be used to maintain more accurate records in the saved profiles 210. For example, the thermal or moisture measurements can be used to calibrate or compensate the nominal values expected from the ESD sensors 110. Ongoing calibration or compensation may enable the ESD health monitor 112 to adapt in readily changing operating conditions of the ESD 108, to accurately detect ESD deformations in conditions where the nominal values slightly differ.

As described in greater detail below, the ESD health monitor 112 uses an array or arrays of the external ESD sensors 110 to detect changes in the surface geometry of the ESD 108 (e.g., from mostly flat to variable thickness). The ESD sensors 110 can include one or more arrays of capacitive sensors 110-1 configured to measure capacitance of the ESD 108 at different physical locations (e.g., different cells, top and bottom surfaces) on an exterior of the ESD 108. One or more inductive sensors 110-2 may similarly detect changes in inductance between these different regions of the ESD 108 when deformations occur. As described above, the ESD sensors 110 may include other sensors 110-*n* (e.g., thermal, temperature, moisture, humidity) to enhance the monitoring. For example, sensor data from the other sensors 110-*n* may enable a calibration of the capacitive sensors 110-1 and the inductive sensors 110-2 for a change in driving conditions. The other sensors 110-*n* may enable further measurements to detect other external properties of the ESD 108 (e.g., high temperature) for providing more accurate warnings about signs of thermal runaway or gas leakage, which may indicate an impending failure. Such a failure may otherwise go undetected if the vehicle 102 instead relies on built-in ESD sensors that are integrated within the ESD 108, or other complex, expensive embedded monitoring circuits used to measure internal states of individual cells, which are different than the ESD sensors 110 and the ESD health monitor 112, to evaluate overall health of the ESD 108.

The ESD health monitor 112 enables the sensor data comparator 208 to detect deviations from nominal values associated with measurements received from the ESD sensors 110. For example, by measuring changes in capacitance between different sensor electrodes of the capacitive sensors 110-1 that are attached or positioned near one or both sides of the ESD 108 (e.g., on a cooling plate that holds a pouch or cell of the ESD 108 in place). A similar approach can be used with rechargeable batteries that include cylindrical cells, packs of cylindrical cells, or prismatic cells. An array of sensors can be distributed on the exterior of the ESD 108 to monitor for variation in capacitive or inductive measurements caused by a shifting relative position of the ESD 108 to the sensors at those locations. For example, the capacitive sensors 110-1 occasionally (e.g., periodically) collect capacitance values associated with the ESD 108 (e.g., before or during a charging session) to detect battery deformation. The capacitance values are provided to the ESD health monitor 112 for reporting to the vehicle 102 or occupants as metrics about ESD health.

### EXAMPLE SYSTEMS

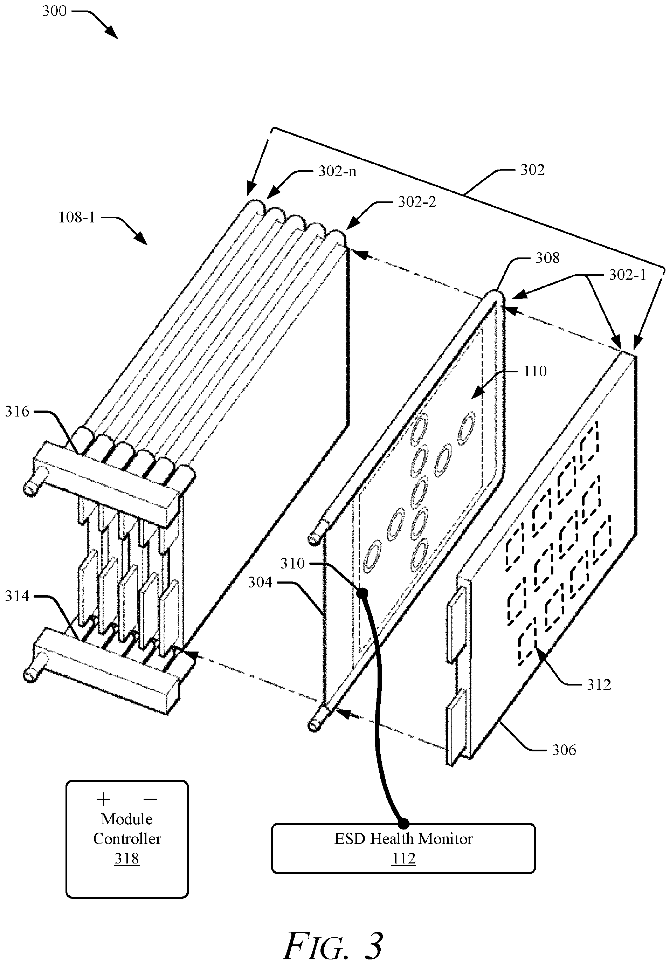

FIG. 3 illustrates an example configuration 300 of a battery system that is integrated with an example external sensing system for monitoring health of vehicle electric energy storage. The configuration 300 is illustrated in FIG. 3 as a partially exploded view of a battery system 108-1, which is an example of the ESD 108 in combination with the ESD sensors 110.

The battery system 108-1 includes a plurality of battery modules 302; the battery modules 302 are individually labeled as battery module 302-1, 302-1, ...., and 302-*n*. Each of the battery modules 302 individually provides a fixed amount of energy storage capacity for the battery system 108-1. When operably coupled in the battery system 108-1, the battery modules 302 provide a combined energy storage capacity equal to a sum of fixed amounts provided by each of the battery modules individually. For ease of description, the battery module 302-1 is described in greater detail with reference to its exploded view in FIG. 3. The other battery modules 302-2 to 302-*n* can each include like components as the battery module 302-1. In some examples, only some of the battery modules 302 are like the battery module 302-1, and other battery modules 302 include different or fewer components. For instance, the battery module 302-1 and 302-2 both include external ESD sensing technology, as described herein; and to minimize costs, the battery module 302-*n* omits the extra hardware.

Each battery module that is configured to perform external ESD sensor based health monitoring may be similar to the battery module 302-1, which includes a respective cooling plate 304 that is similarly sized and shaped to a battery cell 306. The cooling plate 304 provides a mounting surface for the battery cell 306 to provide support and rigidity, as well as thermal dissipation from the battery cell 306 when the battery system 108-1 is charging or under load. The cooling plate 304 is supported by a frame 308 (e.g., metal coated plastic, plastic, composite) that partially surrounds the battery cell 306. The cooling plate 304 may be shared by two different battery cells 306, with each of the battery cells 306 being associated with a different one of the battery modules 302. For example, the cooling plate 304 for the battery module 302-1 may be a shared heat exchanger for the battery cell 306 associated with the battery module 302-2. Every two battery modules 302 may share a single cooling plate 304 between their respective battery cells 306.

The cooling plate 304 is supported by the frame 308, which partially surrounds one or more of the battery cells 306 (which are also commonly referred to as "pouch cells"). The battery cell 306 includes multiple regions 312 associated with different physical areas of the battery cell 306. The frame 308 may encompass the multiple regions 312 within a coolant tube contained within the frame 308 to permit coolant liquid to circle through the battery system 108-1 from a cooling inlet 314 to a cooling outlet 316. The liquid coolant flowing around the cooling plate 304 aids in heat dissipation and thermal regulation of the internal temperature of the battery system 108-1.

Also shown is a module controller 318, which controls functions of the battery system 108-1, including monitoring internal health, storage capacity, voltage, current, input power, load demand, module temperature, and other internal battery parameters. Shown separate from the module controller 318, the ESD health monitor 112 has an interface 310 to each of the battery modules 302, or at least to some of the battery modules 302, such as the battery module 302-1 and the battery module 302-2. The interface 310 enables the ESD health monitor 112 to read sensor measurements captured by the ESD sensors 110 without interfering with the module controller 318. The module controller 318 may include its own battery system monitor circuit including embedded sensors manufactured within the battery cells and external packaging. However, these systems are expensive and drive up battery costs to make EVs even less affordable. As opposed to monitoring from outside the battery system 108-1 from sensor locations that are outside or external to the battery system 108-1 itself, as is done with the ESD sensors 110, which are arranged on the cooling plate 304 or between two cooling plates 304, to monitor for physical deformations in each individual battery module 302, or among each pair of the battery modules 302.

The ESD sensors 110 are arranged on a surface of the cooling plate 304 in a pattern or arrangement that provides sufficient measurement capability across most or all of the regions 312. The regions 312 correspond to surface areas on the cooling plate 304 where the battery cell 306 may swell. Each of the ESD sensors 110 may correspond to one of the different regions 312 to provide an individual sensor measurement for that specific region.

The ESD sensors 110 may be arranged or configured as different size or shaped sensor arrays, including one or multiple types of sensors positioned on the cooling plate 304 at corresponding locations to the regions 312, which are distributed throughout the cooling plate 304. Including a greater quantity of the ESD sensors 110 enables higher fidelity in the health monitoring; however, a sparse sensor arrangement or smaller quantity of the ESD sensors 110 may be sufficient to monitor overall health of the ESD 108, without pinpointing an exact region, if their positions are carefully chosen to detect deformation across all the different regions 312. For example, as shown in FIG. 3, the external ESD sensors 110 may form a two-dimensional array of capacitive sensors 110-1 with a row of five capacitive sensors 110-1 arranged in a longitudinal or horizontal direction and a column of five capacitive sensors 110-1 arranged in a lateral or vertical direction. The row and column share a common capacitive sensor 110-1 among them; or nine capacitive sensors 110-1 in total from the row and column combined. In other implementations, more or fewer capacitive sensors 110-1 can be used along the longitudinal or lateral directions. A sensory array made up of the ESD sensors 110 may also include a sparsely populated array (e.g., in a waffle design) with one or more capacitive sensors 110-1 missing along the longitudinal or lateral directions.

The ESD sensors 110 (e.g., the embedded sensors) may be arranged in at least one of a horizontal array, a vertical array, or a combination of the horizontal array and the vertical array to obtain the measurements from the sensor pads located at different positions along a horizontal axis or a vertical axis of the exterior surface of the ESD 108. For instance, when arranged in rows and columns, the rows and columns of the sensor array may form a T-shape or a cross (e.g., as illustrated). The rows and columns of the sensor array 308-3 are ideally located near a midpoint of the cooling plate 304, e.g., along the lateral direction and the longitudinal direction, respectively. The rows and columns may include same or different quantities of the ESD sensors 110 to capture measurements across different sized ESD exteriors.

In response to detecting abnormal measurements taken from the ESD sensors 110, the ESD health monitor 112 may output an indication of a potential deformation and/or impending failure associated with a region of the battery system 108-1, where the abnormal measurement was detected. In this way, the ESD sensors 110 arranged or embedded in the battery system 108-1 provide external ESD monitoring for determining deteriorating health, including deformations in the exterior or outside packaging, as warning indicators of thermal runaway and outgassing situations.

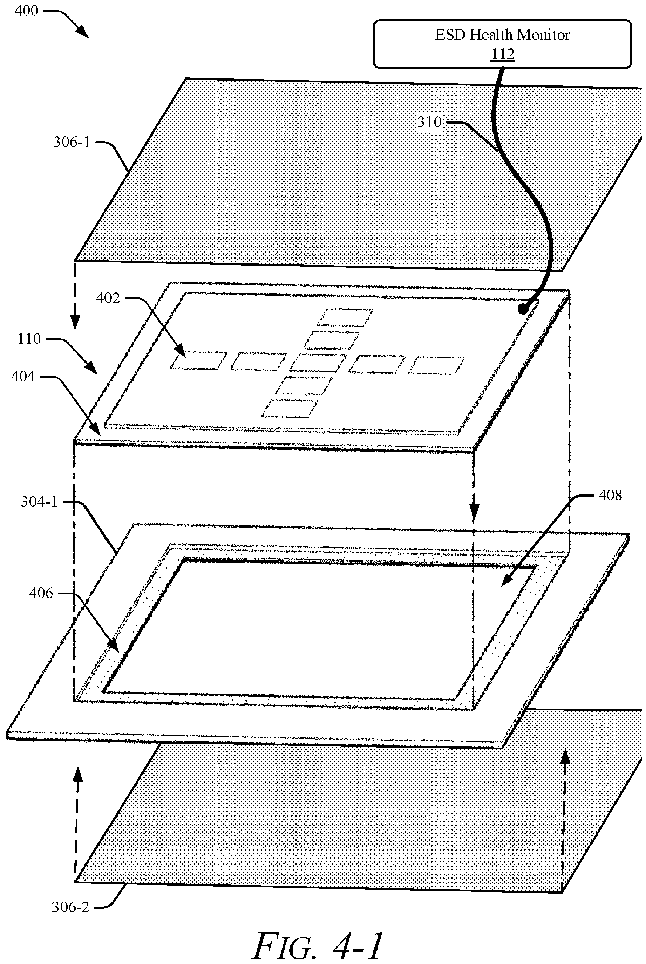

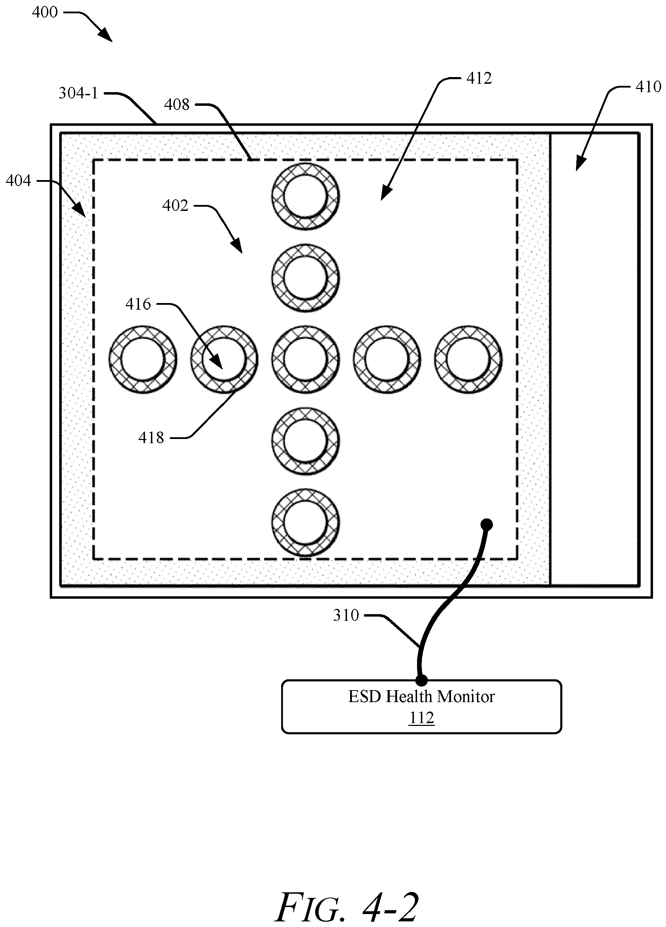

FIGS. 4-1 and 4-2 illustrate additional details of an external sensing system integrated with a vehicle electric energy storage system. FIG. 4-1 shows an exploded view of a vehicle system 400, which includes a cooling plate 304-1 arranged to support the ESD sensors 110 to measure deformation in a battery cell 306-1, which contacts the cooling plate 304-1 on a top surface. The cooling plate 304-1 is an example of the cooling plate 304. In some cases, the cooling plate 304-1 and the ESD sensors 110 are also used to measure deformation in a battery cell 306-2. The battery cell 306-2 may be arranged in contact with the cooling plate 304-1 from an opposite side as the top surface, e.g., where the cooling plate 304-1 contacts the battery cell 306-1. In this way, a single set of the ESD sensors 110 (e.g., a single sensor array) can be inserted (e.g., embedded on the cooling plate 304-1) between pairs of battery cells 306. This enables the ESD sensors 110 to detect abnormal swelling of one or two different battery cells 306.

The ESD sensors 110 include a sensor circuit 402 having multiple sensor pads arranged to measure deformation at the battery cell 306-1 and/or the battery cell 306-2. The sensor circuit 402 arranges the sensor pads in a pattern to provide adequate measurement capability across the different regions 312, which may deform as described above due to various factors. A T-pattern, a cross pattern, a sparse or complete grid, or other arrangement of sensor pads can be used depending on specific physical attributes of the battery cell 306-1 and the battery cell 306-1. If the battery cell 306-1 normally includes one or more recessed regions or indentations in an outer shell that is adjacent to the sensor circuit 402, the sensor pads of the ESD sensors 110 may be spaced and arranged to take measurements away from normal, pre-existing, indentations, grooves, or physical deformations of the battery cell 306-1, which are not a sign of failure. Instead, measurements are recorded from sensor pads placed near mostly flat parts of the battery cell 306-1, which directly contact the cooling plate 304-1.

The sensor circuit 402 is bound by a thermal interface 404, which is configured to conduct thermal energy when contact is made with a corresponding thermal material 406 of the cooling plate 304-1. The thermal material 406 may be recessed in the cooling plate 304-1 to receive the sensor circuit 402 for supporting the ESD sensors 110 enabling the thermal interface 404 to dissipate thermal energy from the sensor circuit 402. Adhesives, metal solders or welds, mechanical fixtures (e.g., pins, screws) and other fasteners or attachment techniques may be used to seat the ESD sensors 110 to be flat relative to the rest of the cooling plate 304-1 and the thermal interface 404. Although primarily described as being integrated on the cooling plate 304-1, in other examples, the sensor circuit 402 may be attached to the ESD 108 (e.g., each battery cell 306 may be monitored by a corresponding sensor circuit 402 that is fixed to the outside of that battery cell 306). Regardless of whether the sensor circuit 402 is attached to the cooling plate 304-1 or individual cells of the ESD 108, the sensor circuit 402 is operable to detect changes in capacitance, inductance, temperature, or other external sensor measurement taken across the multiple regions 312.

As illustrated in FIG. 4-1, the cooling plate 304-1 provides a cavity 408 to permit the ESD sensors 110 to also measure for deformation of the battery cell 306-2. The cooling plate 304-1 is shaped to frame the cavity 408 as a window through which the ESD sensors 110 may measure sensor values from either side of the cooling plate 304-1. The sensor circuit 402 is operable with cavity 408 to measure deformation in either or both the battery cell 306-1 and the battery cell 306-2, using a single sensor circuit, as opposed to individually using two sensor circuits to separately measure each of the battery cells 306. The cavity 408 exposes sensor pads on the sensor circuit 402 to exterior regions of the battery cells 306.

FIG. 4-2 shows a top down-view of the sensor circuit 402 as it is integrated in the vehicle system 400. The battery cells 306-1 and 306-2 are omitted for simplicity in the drawings; the battery cell 306-2 may be arranged beneath the sensor circuit 402 when the battery cell 306-1 is positioned above the sensor circuit 402. In FIG. 4-2, the sensor circuit 402 is shown arranged within a perimeter of the cavity 408 formed in or through the cooling plate 304-1. The sensor circuit 402 includes a plurality of sensor pads 416. Each of the sensor pads 416 in the sensor circuit 402 includes an optional grounding region 418, which may help reduce noise (e.g., hatching to reduce parasitic capacitance) from propagating between the sensor pads 416. When capacitive sensors are used, the sensor pads 416 may form solid conductive surfaces (e.g., copper). When inductive sensors are used, the sensor pads 416 can include spirals conductors (e.g., metal traces) instead of a solid conductive surface.

A solder resist area 410 of the sensor circuit 402 is shown separate from a contact area 412 of the sensor circuit 402, that fills the cavity 408 in-between the sensor pads 416 to provide a rigid surface for supporting and contacting the battery cells 306-1 and 306-2 (e.g., when placed on or under the cooling plate 304-1). The contact area 412 may be a printed circuit board (PCB) layer and the solder resist area 410 may be formed integral with the same PCB layer to support power electronics, microcontrollers, etc. Contact between the battery cell 306-1 and/or the battery cell 306-2 may occur with direct contact at the contact area 412 indirectly (e.g., thermal contact) from touching the thermal interface 404.

Although not shown, the sensor circuit 402 may include a top cover and a bottom cover (e.g., a metal cap) to protect the sensor circuit 402 from a harsh environment and/or abrasions from rubbing against the exterior of the ESD 108. The top cover provides a solid surface relative to an exterior of an ESD (e.g., the battery cell 306-1) when integrated in the vehicle 102. The ESD sensors 110 may be affixed to or on a bottom or underside surface of the top cover. In terms of the bottom cover, the ESD sensors 110 may be affixed to or on a top or upper surface of the bottom cover, which provides another solid surface relative to the exterior of the ESD (e.g., the battery cell 306-2). The ESD health monitor 112 shares the interface 310 to the sensor circuit 402, which may include control circuitry for outputting sensor data to the ESD health monitor 112.

The ESD health monitor 112 utilizes the ESD sensors 110 to detect changes in the surface geometry of the battery cells 306 by measuring changes in capacitance, inductance, temperature, or other sensor variable at or among the various ESD sensors 110. As described in greater detail below, in the case of a deformed battery, the surface of the battery cells 306 become rounded (e.g., forming a bulge). For example, depending on the direction, the deformations may result in much higher capacitance values measured at a capacitive sensor located in a shallow cavity under or near the deformation (which is allowed to penetrate or shrink the cavity).

### EXAMPLE APPLICATION

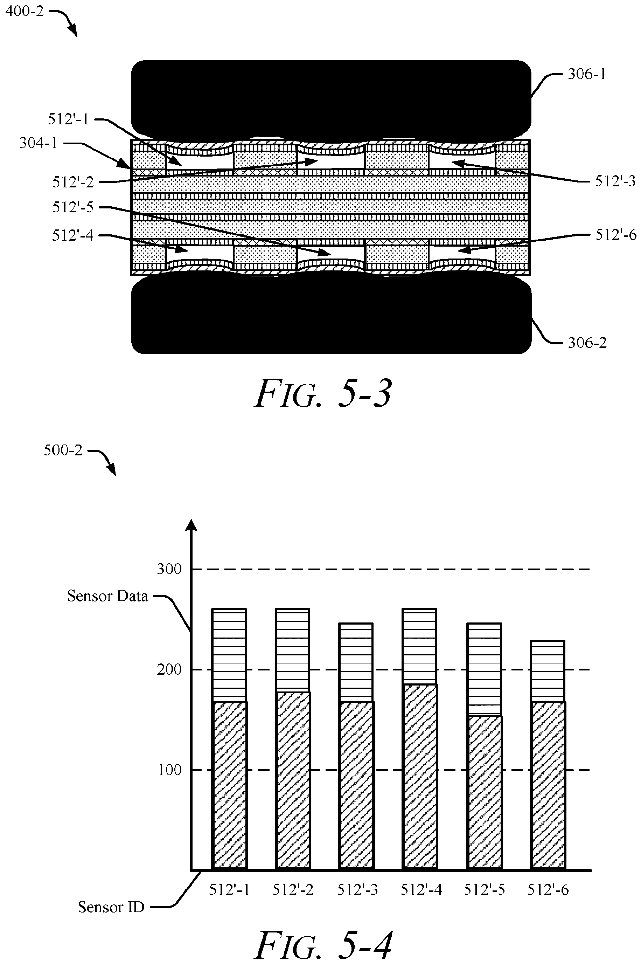

FIGS. 5-1 through 5-4 illustrate an example vehicle situation in which external sensing is used for monitoring health of vehicle electric energy storage in accordance with techniques of this disclosure. FIGS. 5-1 and 5-3 show cross-sectional views of a vehicle system 400-1 and a vehicle system 400-2, which are each examples of the vehicle system 400. FIGS. 5-2 and 5-4 show charts 500-1 and 500-2 each representing sensor data that is monitored from the interface 310 between the sensor circuit 402 and the ESD health monitor 112.

For example, FIGS. 5-1 and 5-2 illustrate the vehicle system 400-1 when it is operating under nominal ESD conditions; the battery cells 306-1 and 306-2 show no physical deformation. The exterior of the battery cells 306-1 and 306-2 is mostly flat and consistent relative either side of the cooling plate 304-1. FIGS. 5-3 and 5-4 illustrate the vehicle system 400-2 as it experiences a potential ESD failure. The battery cells 306-1 and 306-2 are visibly deformed in FIG. 5-3; physical deformation (e.g., swelling, bulging) occurs on the exterior of the battery cells 306-1 and 306-2 such that one or both are no longer flat against the cooling plate 304-1. The pressure produced against the cooling plate 304-1 by the bulging battery cells 306-1 and 306-2 causes some parts of the cooling plate 304-1 to deflect inward, and away from the regions 312 of the battery cells 306-1 and 306-2 that are deformed. For example, as made clear from FIG. 5-3, if the cavities 512 are uncovered, the exterior of the battery cells 306-1 and 306-2 may deflect into the recesses of the cavities 512, which may cause a measurable change in capacitance or inductance at a corresponding one of the sensor pads 416, depending on the process used.

The chart 500-1 represents the sensor data captured from the sensor circuit 402 when the battery cells 306-1 and 306-2 are not deformed. In contrast, the chart 500-2 juxtaposes the sensor data captured under the nominal conditions illustrated in FIG. 5-1, with different sensor data captured from the sensor circuit 402 when the battery cells 306-1 and 306-2 are deformed and about to fail (e.g., burst, combust).

The ESD health monitor 112 is configured to evaluate differences between the measurements recorded in the chart 500-1 and those that are recorded in the chart 500-2. Evaluation of changes in these measurements enables the ESD health monitor 112 to detect conditions with exterior portions of the battery system 108-1 that are used as indicators of good or poor battery health. The sensor data comparator 208 may cause the ESD health monitor 112 to determine whether the battery system 108-1 has a physical deformation or other variation in size or shape based on the comparisons. For example, based on whether the measurements in the chart 500-2 are within a sufficient tolerance or threshold established by the measurements originally recorded in the chart 500-1, the sensor data comparator 208 outputs an indication about whether the measurements are acceptable or not healthy. In response to the latter, the ESD health monitor 112 may trigger a warning or output an alert to the vehicle 102 to cause a vehicle safety function to intervene (e.g., a protection circuit).

The vehicle systems 400-1 and 400-2 each embed their respective ESD sensors 110 within the cooling plate 304-1 at different positions arranged near exterior surface regions (e.g., the regions 312) of either of the battery cells 306-1 and the battery cell 306-2. The cross-section of the vehicle systems 400-1 and 400-2 highlights their different layers or structures. These layers fit within the thickness of the cooling plate 304-1 and can include additional or fewer layers and structures than shown. For example, the layers of the vehicle system 400-1 and 400-2 may be approximately a thickness of a PCB assembly (e.g., a few millimeters). As illustrated, the vehicle systems 400-1 and 400-2 provide dual side monitoring of ESD health from a shared cooling plate arranged between a pair of battery cells or ESD pouches. In other examples, the vehicle systems 400-1 and 400-2 may be used to monitor only one battery cell arranged on one side of the cooling plate.

Starting from the side of the cooling plate 304-1 that is closest to the battery cell 306-1, an optional upper cap 502-1 (e.g., made of metal) provides rigidity and strength to the systems 400-1 and 400-2; which may improve durability over the operating life of the vehicle 102. For instance, the upper cap 502-1 may prevent abrasion, wear, or environmental debris from interfering with internal components of the systems 400-1 and 400-2, which are provided by the other layers shown. These and other layers described may be thin and flexible to allow deformations in the ESD 108 to cause proportional inward deflections in the upper cap 502-1 and other layers of the systems 400-1 and 400-2. On an opposite side of the cooling plate 304-1, which is closest to the battery cell 306-2, an optional lower cap 502-2 (e.g., made of metal) provides similar function (e.g., rigidity, strength, protection) to the systems 400-1 and 400-2 as the upper cap 502-1 provided above. The embedded ESD sensors 110 are located in the sensor layers 508-1, 508-2, and 508-3 are affixed to an opposite side of the upper or lower cap layer 502-1 and 502-2 (e.g., from a side of that cap layer that is adjacent to the exterior surface of the ESD 108).

From the upper cap 502-1 down, the systems 400-1 and 400-2 each include a thermal metal layer 504 (e.g., a copper layer). The thermal metal layer 504 is thin and formed without any solder or with minimal resistance properties so as to improve heat transfers from the systems 400-1 and 400-2 to cooling regions (e.g., the thermal material 406) of the cooling plate 304-1.

Next, a plurality of substrate layers 506-1 to 506-5 (e.g., PCB layer, prepreg layer) are stacked and interspersed with a plurality of sensor layers 508-1 to 508-3 and a plurality of signal/ground plane layers 510-1 and 510-2. The stack of layers 506, 508, and 510 is bound between outer layers of the systems 400-1 and 400-2 (e.g., under the upper cap 502-1, above the low cap 502-2) to provide a plurality of sensor cavities of dielectric (e.g., air pockets) between the sensor pads 416 and the exteriors of the battery cells 306-1 and 306-2.

The separation layers 506-1 to 506-5 give the systems 400-1 and 400-2 a particular size and shape that encompasses the cavity 408 and is contoured with either the top or bottom surface of the cooling plate 304-1. Isolation between conductive layers is achieved with a non-conductive substrate material (e.g., prepreg), which fills the separation layers 506-1 to 506-5 to cause a certain separation distance between adjacent conductive layers.

The sensor layers 508-1 to 508-3 are conductive layers that support the sensor pad 416 of each of the integrated ESD sensors 110 (e.g., a spiral inductive copper element, a uniform capacitive sensing surface). The signal/ground plane layers 510-1 and 510-2 are conductive layers that support the grounding region 418 of each of the integrated ESD sensors 110 and electrically couple the sensor layers 508-1 to 580-3 to the interface 310 shared with the ESD health monitor 112.

In the situation shown in FIG. 5-1, six of the ESD sensors 110 are shown as being integrated in the vehicle system 400-1; each of the ESD sensors 110 is associated with one of six sensor cavities 512-1 through 512-6. During these nominal conditions, the sensor cavities 512-1 to 512-6 are of a particular size and cause their corresponding sensors to output sensor data or measurements like those shown in the chart 500-1. The measurements (e.g., sensor data) from the sensor circuit 402 can be transmitted on signal/ground plane layers 510-1 and 510-2 to enable a microcontroller or processing element, which executes the ESD health monitor 112, to establish the baseline measurements, which can be used to detect potential deformations in the battery cells 306-1 or 306-2.

In operation, under a potential failure condition, a compression of the substrate layer 506 occurs near a cavity region 512 within the multiple layers of the sensor circuit 402. Each of the embedded sensors in the sensor circuit 402 is associated with a different cavity region 512 within the multiple layers. With this in mind, in the situation shown in FIG. 5-3 the vehicle system 400-2 is experiencing a potential failure condition. As illustrated, the battery system 108-1 at the battery cells 306-1 and 306-2 are increasing in size and causing portions of their exterior to push the layers 502-1, 502-2, and 504 closer sensor layers 508-1 to 508-3. Deformations in the exterior size of the battery cells 306-1 and 306-2 cause deformed cavities 512'-1 to 512'-6 near the ESD sensors 110 in the sensor layers 508-1 to 508-3. This causes a change in dielectric constant at the sensor pads 416 due to less air or dielectric being between the battery cells 306-1 and 306-2 and the sensor pads 416 embedded at those locations. The sensor cavities 512-1 through 512-6 transform because of the ESD bulges to be deformed cavities 512'-1 through 512'-6. A change in sensor data recorded near the deformed sensor cavities 512' may cause the ESD health monitor 112 to report a potential failure condition with the ESD 108, including a cell or pouch that is failing.

FIG. 5-3 illustrates just one example of deformation, where each of the sensor cavities 512-1 to 512-6 becomes one of the deformed cavities 512'-1 to 512'-6. In other cases, only some of the cavities 512-1 to 512-6 change size. With less deformation on the exterior of the battery cells 306-1 and 306-2, some of the cavities 512 may keep their shape and only some will become the deformed cavities 512'. This way, early warning of deformation at a particular one of the regions 312 in the battery cells 106-1 and 106-2 can be pinpointed as potentially failing. The ESD health monitor 112 (e.g., a battery microcontroller) may disable a failing battery cell and cause the vehicle 102 performance to be reduced to minimize further wear on the ESD 108, until the dead cell or the ESD 108 assembly can be replaced.

In FIG. 5-4, the sensor data shows how as the battery cells 306-1 and 306-2 expand or deform, the upper cap 502-1 and/or the lower cap 502-2 are deflected inward from their respective sides of the cooling plate 304-1. This causes a change in the capacitance or inductance measured near the cavities 512. The sensor pad 416 of each of the capacitive sensors 110-1 may measure the capacitance *C* of the dielectric material within each of the sensor cavities 512. The capacitance *C* measured at each of the cavities 512 is indicated in the chart 500-1. The charts 500-1 and 500-2 each label these capacitance measurements with general sensor units, not intended to represent a real count, capacitance, or inductance, but instead to more easily convey how the described techniques with regard to capacitance monitoring can apply similarly across different types of the ESD sensors 110.

Three of the capacitive sensors 110-1 are shown embedded in the sensor layer 508-1 near a first surface of the cooling plate 304-1. Another three capacitive sensors 110-1 are shown embedded in the sensor layers 508-2 and 508-3, near a second surface of the cooling plate 304-1 that is opposite the first surface. At the sensor pad 416 corresponding to each of three of the capacitive sensors 110-1 in the sensor layer 508-1, the capacitance of the cavities 512-1, 512-2, and 512-3 is measured. At the sensor pad 416 corresponding to each of three of the capacitive sensors 110-1 in the sensor layers 508-2 and 508-3, the capacitance of the cavities 512-4, 512-5, and 512-6 is measured. When deformation in either of the battery cells 306-1 or 306-2 occurs, the nearest sensor cavity (e.g., one of the cavities 512) partially collapses to cause the dielectric constant of that cavity to change. The cavities 512' have a shallower depth relative to the cavities 512 prior to compression from a bulging battery cell. The vehicle system 400 is formed of copper, PCBRG, and other somewhat malleable materials that allow the cavities 512 to fill the air and reduce the amount of dielectric material (e.g., air) inside the cavities 512. The sensor cavities 512 can change shape and deflect inward in response to sufficient force caused by a deformation in the exterior of the battery cells 106-1 and 106-2. This way some of the ESD sensors 110 in the sensor circuit 402 are used to monitor for deformation in the battery cell 306-1, and a remainder of the ESD sensors 110 are used to monitor for deformation in the battery cell 306-2.

A difference in capacitance resulting from swelling is measurable when the cavities 512' change shape and encase a smaller volume of air-dielectric than the cavities 512. Similar techniques may be utilized with variation in the design of the layers of the vehicle system 400 to provide similar ESD health monitoring for battery pouches and cells of various shapes, including cylindrical cells, packs of cylindrical cells, and prismatic cells, each of which may be susceptible to swelling from outgassing.

### EXAMPLE PROCESSES

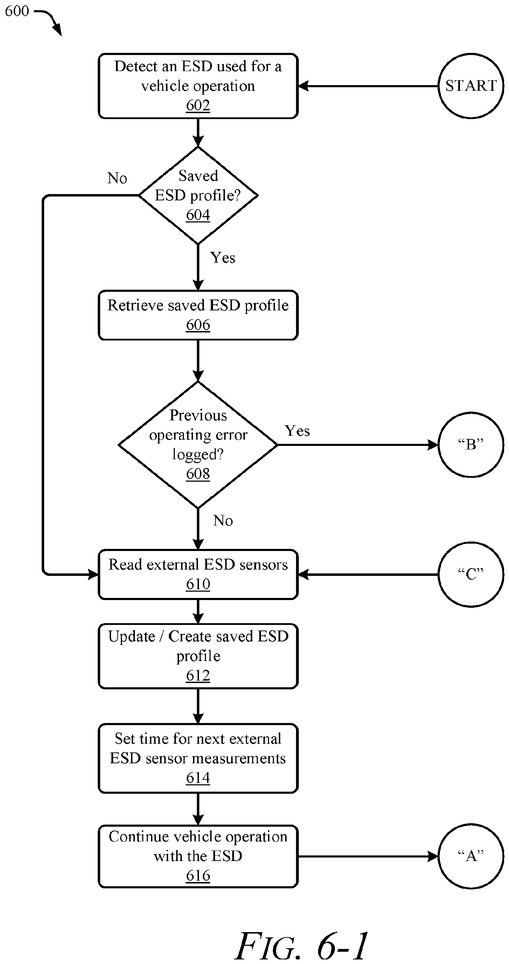

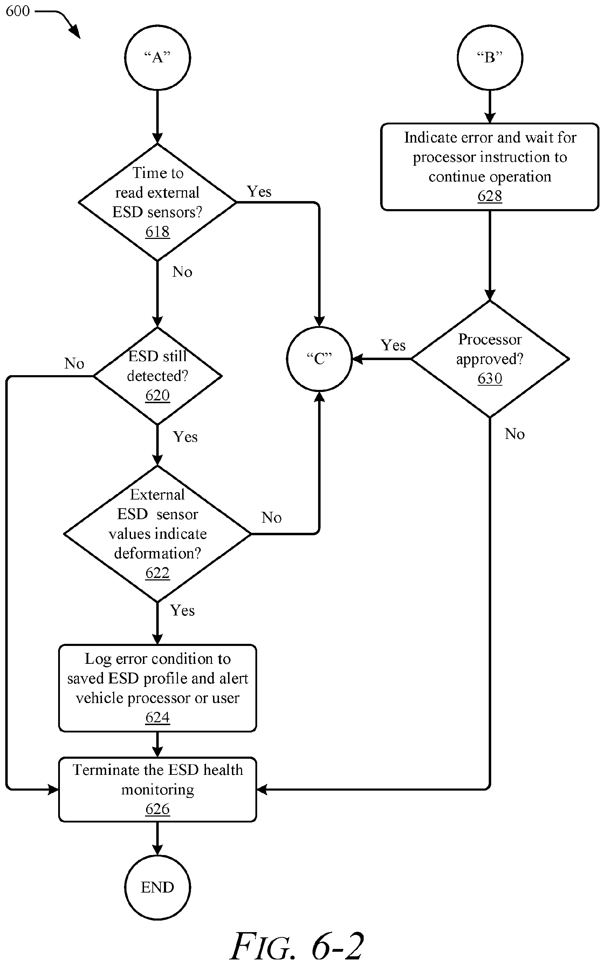

FIGS. 6-1 and 6-2 illustrate an example flow chart 600 for monitoring health of vehicle electric energy storage. The flow chart 600 is shown as operations (or acts) 602 through 630 being performed across two parts illustrated in the separate FIGS. 6-1 and 6-2; these two parts are connected by transition steps labeled as "START", "END", "A", B", and "C". However, the flow chart 600 may be changed or include steps arranged in different ways; the process indicated by the flow chart 600 is not necessarily limited to the order or combinations in which the operations are shown herein. Further, any one of one or more of the operations may be repeated, combined, or reorganized to provide other flow charts. In portions of the following discussion, reference may be made to entities detailed in FIGS. 1 through 5-4, reference to which are made for example only. The techniques are not limited to performance by one entity or multiple entities. Although the flow chart 600 provides example operations for a vehicle system, the same or similar operations may be implemented to detect deformation in various systems, including embedded and backup batteries in other applications besides for vehicles.

In operation, the vehicle 102 may perform the operations 602 to 630 to monitor the ESD 108 when being used to supply a vehicle load or being charged. At the START, the ESD health monitor 112 may execute the operation 602. At the operation 602, the ESD health monitor 112 may perform a handshake with the ESD 108 or another component on the vehicle 102 to detect the ESD 108. A microcontroller of the ESD 108 may report its presence on a vehicle communication bus. The ESD 108 110 may send data packets identifying itself and provide configuration and setup information to the vehicle 102 and/or the ESD health monitor 112. Based on the data packets received from the ESD 108, the ESD health monitor 112 can check the saved ESD profile / history 210 for one associated with the ESD 108.

At operation 604, it is determined whether the ESD 108 has previously been identified based on whether the ESD detected at the operation 602 has a saved ESD profile (or history). For example, the ESD health monitor 112 queries the ESD profile / history 210 for an identifier of the ESD 108 detected in the operation 602. If no profile is saved or created, then the flow chart 600 proceeds from the operation 604 to execute the operation 610. If a saved profile is identified for the ESD 108, then the flow chart 600 proceeds from the operation 604 to execute the operation 606.

At operation 606, if the ESD 108 has been previously identified, a saved profile for the ESD 108 is retrieved. For example, the ESD health monitor 112 retrieves the saved ESD profile / history 210 associated with the ESD 108 if the ESD 108 has previously been identified by the ESD health monitor 112.

At operation 608, it is determined whether a previous operating error has been logged. For example, the ESD health monitor 112 determines whether the saved ESD profile / history 210 or another log associated with the ESD 108 indicates a previous charging or operating error was logged for the ESD 108 during previous use. At the operation 608, if a previous charging error has not been logged, the flow chart 600 proceeds to the operation 610. However, if there is a previous error recorded, the flow chart 600 progresses to "B" and executes the operation 628 instead of the operation 610.

At the operation 610, if a previous charging error has not been logged or if the ESD has not been previously identified, then external ESD sensors are read. For example, the capacitive sensors 110-1, the inductive sensors 110-2, or other types of the ESD sensors 110 are checked by the ESD health monitor 112 for sensor data indicating current measurements taken near the ESD 108, to detect deformation of an exterior portion of the ESD 108.

At operation 612, a saved ESD profile is created or updated based on values read from the ESD sensors at the operation 610. For example, the sensor data comparator 208 of the ESD health monitor 112 updates long-term (e.g., over a number of measurement cycles) and short-term (e.g., for the most recent measurement cycle) averages for the capacitance, inductance, or other sensor values that measure deformation in the cavities 512. The sensor data comparator 208 may also determine long-term and short-term standard deviations, variances, ranges, and/or minima for the sensor values.

At operation 614, a time to capture or read a next set of external ESD sensor measurements is set or otherwise determined. For example, the ESD health monitor 112 and/or the sensor comparator 208 sets or reads a predefined value, which is used to set a timer for obtaining additional sensor measurements or values from the ESD sensors 110. The ESD health monitor 112 and/or the sensor comparator 208 may be preprogrammed to obtain or read the ESD sensors 110 at a certain frequency (e.g., every 10 seconds).

At operation 616, the vehicle operation (e.g., charging session) using the ESD is allowed to continue and the flow chart 600 proceeds to "A". For example, the ESD health monitor 112 initiates, resumes, or otherwise allows charging of the ESD 108 to continue. The ESD health monitor 112 may allow energy to be drawn from the ESD 108 to supply a vehicle load. The vehicle operation may not be allowed to continue and proceed to "A" until the sensor data comparator 208 determines that no battery deformation is indicated by the sensor data read at the operation 610.

At operation 618, it is determined whether it is time to read the external ESD sensors. For example, the ESD health monitor 112 determines whether it is time for the next measurement cycle for the capacitive sensors 110-1, the inductive sensors 110-2, or any of the other sensors 110-n. If it is time to read the capacitive sensors 110-1 and/or the inductive sensors 110-2 (e.g., for the next measurement cycle), then the ESD health monitor 112 proceeds to "C" where in executing the operations of the flow chart 600, it returns to execute the operation 610.

At the operation 620, if it is not time to read the capacitive sensors (again), it is determined whether the ESD is still detected as being used for the vehicle operation, or whether the ESD is disabled or not being used on the vehicle 102. For example, the ESD health monitor 112 determines whether the ESD 108 is still enabled and being charged or allowed to supply power to loads.

At the operation 620, if the ESD is not detected or no longer actively being used to perform a vehicle function, then flow chart 600 proceeds to the operation 626 and terminates the ESD health monitoring. For example, if a wireless charging operation with the ESD 108 is ongoing in the environment 100, and the ESD health monitor 112 determines that the vehicle 102 has moved away from the wireless charging station 104-2, the ESD health monitor 112 may stop monitoring the ESD 108 and may cause or itself terminate the charging session to reduce risk of injury or damage. A new ESD health monitoring session may pick up where the last one ended, for example, to monitor the health of the ESD 108 after switching modes and supplying energy to vehicle loads.

At operation 622, if the ESD is still detected for an ongoing vehicle operation, it is determined whether the sensor data (e.g., the capacitance values, the inductance values) indicate deformation of the ESD. For example, the sensor data comparator 208 determines whether the capacitance at any of the sensor cavities 512 is different than nominal measurements or previous measurements recorded in the ESD profile / history 210.

The sensor data comparator 208 may identify potential deformation of the ESD 108 if the difference between the short-term average of capacitance values and the long-term (e.g., all previous measurement cycles or a set number of previous measurement cycles) average of capacitance values is greater than a threshold value. Because swelling may introduce an air gap in the ESD 108, an outer cover of the ESD 108 that is adjacent to the upper cap 502-1 or the lower cap 502-2 can cause their deflection inward towards the capacitive sensors 110-1 that are located between the caps 502-1 and 502-1 within the sensor cavities 512. The short-term average will be significantly lower than the long-term average before the deformation.

Similarly, the capacitance comparator 208 may identify a deformation from the short-term standard deviation, variance, or range being greater than a respective threshold value. A deformation may also be indicated by the difference between the short-term and long-term standard deviation, variance, or range being greater than another threshold value. The short-term minimum or a comparison to the long-term minimum may indicate that the ESD 108 has swelled.

Often times, the deformation is caused by swelling or enlargement of the ESD 108 that results in a variable distance or an air gap within the multiple layers 502, 504, 506, and 508, which are between an outer layer of the sensor circuit nearest the exterior surface of the ESD 108 and the at least one sensor pad 416.

In some examples, when a cap layer arranged is between the substrate layers 506-1, 506-2, 506-3, 506-4, or 506-5, and the exterior surface of the ESD 108 (e.g., the upper cap 502-1, the lower cap 502-2), this cap layer comprises a rigid material (e.g., metal) that is allowed to flex due to the compression caused from a bulging battery cell or pouch, to allow the exterior surface of the ESD 108 to move closer to the at least one sensor pad 416 than the nominal distance maintained by the substrate layers 506-1, 506-2, 506-3, 506-4, or 506-5 prior to the compression.

At operation 624, if the ESD sensor values indicate deformation, an error condition is logged in the saved profile, and the user is alerted. For example, the ESD health monitor 112 logs the error condition in the saved ESD profile / history 210 or other record associated with the ESD 108 in response to the capacitance values indicating deformation of the battery cell 306-1 and/or 306-2. The ESD health monitor 112 also provides an alert of the error condition to the vehicle 102 and/or a user (e.g., the driver, an occupant). For example, the ESD health monitor 112 may output an alert to the vehicle communication bus to notify other vehicle systems about the unsafe ESD condition. As mentioned in reference to FIG. 2, the ESD health monitor 112 may control a graphical user interface in the vehicle 102 and cause the alert about the bad ESD to be provided on the display 202 in the vehicle 102 (e.g., an infotainment display in the central console), or a remote display (e.g., integrated into or on the ESD 108 (e.g., a small screen or LED that can indicate an error condition), or on the charging stations 104.

At the operation 626, the ESD health monitoring is terminated. For example, the ESD health monitor 112 causes the vehicle 102 to terminate a charging session or cease operating using the ESD 108.

The flow chart 600 proceeds to the operation 628 from "B", after having determined during the operation 608 that a previous operating error has been logged for the ESD 108.

At the operation 628, the error is indicated while waiting for instructions for instructions to continue. For example, the ESD health monitor 112 determines that the saved ESD profile / history 210 or another log associated with the ESD 108 indicates a previous charging or operating error was logged for the ESD 108 during previous use (e.g., during the operation 624). For example, the ESD health monitor 112 may optionally pause a charging session with the ESD 108 in response to capacitance values indicating deformation of the ESD 108.

The previous charging error may be output as an alert to a vehicle processor or the user. The processor 204 may determine whether to continue using the ESD 108 (e.g., if continued use is safer than not) or output a notification requesting user input (e.g., from a driver, from a technician) acknowledging the unsafe ESD and/or overriding the pause in the vehicle operation with the ESD.

For example, the processor 204 is requested or the user is asked, for responding to the ESD health monitor 112 whether to continue the vehicle operation or not. For example, the ESD health monitor 112 may indicate a previous charging error on the display and prompt the user to indicate whether using the ESD 108 should continue.

At operation 530, it is determined whether the processor or a user approved continuing use of the ESD 108. For example, the ESD health monitor 112 determines whether the user indicated that the charging session for the ESD 108 should continue or be initiated despite the previous error. The driver, a technician, or a processor controlled vehicle camera may have control to determine to initiate or continue the vehicle operation with the ESD 108 after performing a visual inspection of the ESD 108 exterior and there are no visible signs of deformation. The driver, technician, or processor may also be aware of a repair or replacement to the ESD 108, which may make the previous error no longer applicable for an indication of ESD health.

If the continuing or commencing the vehicle operation with the ESD 108 is approved at the operation 630, the flow chart 600 proceeds to "C" and the operation 610 to continue the process of reading the ESD sensors 110 for possible deformation in the ESD 108. In such situations, the ESD health monitor 112 may clear or delete the previous charging error from the saved ESD profile / history 210 associated with the ESD 108. If the user, the processor 204, and/or the technician do not approve continuing or commencing the charging, the flow chart 600 proceeds to the operation 626 and terminates.

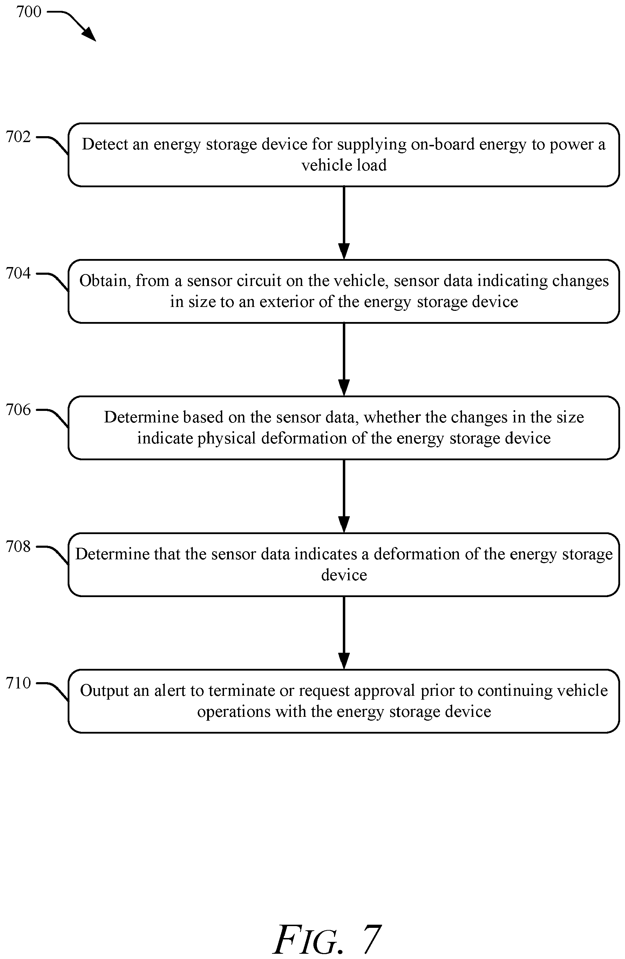

FIG. 7 illustrates an example process 700 for monitoring health of vehicle electric energy storage. The process 700 is shown as a series of operations (or acts) 702 to 710, which are performed in, but not necessarily limited to, the order or combinations in which the operations are shown herein. Further, any one of one or more of the operations 702 to 710 may be repeated, combined, or reorganized to provide other methods. In portions of the following discussion, reference may be made to entities or operations detailed in FIGS. 1 through 6-2; reference to which is made for example only. The techniques are not limited to performance by one entity or multiple entities of one operation or multiple operations.

At step 702, an energy storage device for supplying on-board energy to power a vehicle load is detected. For example, the processor 204 may execute operations of the ESD health monitor 112 to determine that the ESD 108 is a storage device on the vehicle 102, which may fail. The ESD health monitor 112 may determine an identification of the ESD 108. Based on the identification of the ESD 108, the ESD health monitor 112 may query the saved ESD profile / history 210 for information about nominal measurements expected when monitoring the ESD 108.

At step 704, sensor data indicating changes in size to an exterior of the energy storage device are obtained from a sensor circuit on the vehicle. For example, a saved profile or a default profile associated with the identification of the energy storage device is retrieved and then used to determine whether from comparing new sensor data to the saved profile or the default profile, any physical changes in the size of the ESD 108 indicate there is physical deformation.

At step 706, based on the sensor data, whether the changes in the size indicate physical deformation of the energy storage device is determined. For example, capacitance values may be obtained from multiple capacitive sensors 110-1, which are integrated into or on the cooling plate 304-1. For example, the ESD health monitor 112 obtains or reads capacitance values from the capacitive sensors 110-1. The capacitive sensors 110-1 are laid out to obtain the capacitance values from different positions along a horizontal (or longitudinal) axis or a vertical (or lateral) axis of the ESD 108.

In some implementations, the ESD health monitor 112 may ignore or delete the capacitance values or other sensor measurements for a measurement cycle of the monitoring session. For example, the measurements may be ignored in response to detecting or receiving notification of a vibration event (e.g., the vehicle 102 traveling over train tracks). The vibration event may be detected using an inertial measurement unit of the ESD health monitor 112, the vehicle 102, or the ESD 108, and be an indication of poor sensor results. In response to detecting a vibration event, the ESD health monitor 112 may ignore the measurements for that cycle.

At step 708, a deformation of the energy storage device is determined from the sensor data. For example, the sensor data comparator 208 may analyze the capacitance values and determine whether they indicate battery deformation, which is caused by swelling or enlargement of the ESD 108 resulting in a smaller distance or narrower air gap between the sensor circuit 402 and an exterior of the ESD 108. In other words, the deformation may cause the cavities 512 to shrink and become the deformed cavities 512'.

The sensor data comparator 208 may use a variety of analyses and statistical methods to identify the battery deformation. For example, battery deformation may be determined based on at least one of the following: the current (or short-term) average of the capacitance values being less than the previous average (or long-term or rolling averages) of capacitance values or being less than a threshold average value, which may be set for the particular device based on initial averages or based on the type of ESD. The standard deviation of the capacitance values being greater than the previous standard deviation of capacitance values or a threshold standard deviation value; or at least one of the capacitance values (e.g., a minimum capacitance value) being below a threshold value. The threshold values may be determined based on the saved ESD profile / history 210 or a default profile associated with the ESD 108.

In other implementations, whether the measurements indicate that any of the sensor pads is closer to the exterior surface than the nominal distance maintained by the substrate layer from is determined from using a machine-learned model; the model can identify the deformation based on capacitance values or inductance values included in the measurements. In other words, determining whether the changes in the size indicate the physical deformation may include using a machine-learned model to identify the physical deformation based on capacitance values or inductance values in the sensor data and whether they deviate from nominal or previously recorded values.

For example, the sensor data comparator 208 may use a machine-learned model to identify the battery deformation based on the sensor data (e.g., capacitance values, inductance measurements, pressure readings). The machine-learned model may be trained to receive the sensor data output from the sensor circuit 402 over the interface 310 and classify the ESD 108 deformed or not deformed. The machine-learned model may perform classification, tracing, and/or other tasks related to identifying potential battery deformations during charging or other vehicle operations involving the ESD 108.

For classifications, the machine-learned model can be trained using supervised learning techniques. For example, the ESD health monitor 112 or an offline system can train the machine-learned model with training data (e.g., ground truth data) that includes capacitance values labeled as deformed or not deformed. The labels can be manually applied by engineers or provided by other techniques (e.g., based on data from other charging systems). The training dataset can include capacitance values like those input to the machine-learned model during the operation of the ESD health monitor 112.

The machine-learned model can be trained offline, e.g., in a training computing system, and then provided for storage and implementation on one or more wireless chargers. For example, the training computing system can include a model trainer. The training computing system can be included in or separate from the processor implementing the machine-learned model.

In some implementations, the machine-learned model may implement logistic regression, a decision tree, or a multi-layer perceptron. These machine-learned models may be chosen if the processor of the ESD health monitor 112 has limited processing capabilities. If the processor has greater processing capabilities, additional types of models may be employed. Logistic regression uses a Sigmoid function to map the final output into an interval between zero and one, representing the probability of the input being in each category (e.g., deformed or not deformed). Extracted features from the capacitance values or other sensor data monitored by the ESD health monitor 112 may be used to improve the performance of logistic regression. Decision trees use a white-box model to show which extracted features are important in the classification. A multi-layer perceptron is a feed-forward neural network that uses linear combinations of the features and a non-linear activation function to generate the classification output. Weights of the activation function are updated or learned iteratively using a gradient-based optimization method (e.g., via backpropagation) during the training phase.

The ESD health monitor 112 may also obtain or read sensor measurements including capacitance values periodically. For instance, in response to a cycle time expiring, The ESD health monitor 112 obtains new sensor data. Based on the new sensor data (in comparison to the old or previously logged data) the ESD health monitor 112 determines whether new changes in the size indicate the physical deformation. Thus, in response to a cycle time expiring, the ESD health monitor 112 obtains or reads new capacitance values from capacitive sensors. The sensor data comparator 208 determines whether the new capacitance values or other new sensor measurements indicate battery deformation.

At step 710, an alert to terminate or request approval prior to continuing vehicle operations with the energy storage device is output. For example, the ESD health monitor 112 may cause a charging session or other vehicle operation involving the ESD 108 to terminate, not initiate, not continue, or wind-down as a way to prevent damage or injury from the deformation. The ESD health monitor 112 may terminate a charging session in response to determining that capacitance values or new capacitance values (e.g., from a later measurement cycle) indicate battery deformation. The ESD health monitor 112 may also log the charging error or battery deformation in the saved ESD profile / history 210 in an entry or record associated with the ESD 108. In some cases, outputting the alert is to a vehicle processor. The output of the alert may drive a graphical display and be provided as an alert to a vehicle occupant or user (e.g., on the display 202), to warn and request approval to continue using the ESD 108.

### ADDITIONAL EXAMPLES

In the following section, additional examples are provided.

Example 1: A system comprising: a sensor circuit for monitoring health of an energy storage device installed in a vehicle, the sensor circuit comprising multiple layers of stacked material arranged fixed near an exterior surface of the energy storage device, the multiple layers including: at least one sensor layer to support individual sensor pads for a plurality of embedded sensors; at least one substrate layer to isolate and maintain the individual sensor pads supported by the sensor layer at a nominal distance from the exterior surface; at least one signal layer operatively coupled to the individual sensor pads to output measurements from the sensor pad of each of the embedded sensors; and at least one processor operable with the sensor circuit to: determine, based on the measurements, whether any of the sensor pads is closer to the exterior surface than the nominal distance maintained by the substrate layer; and output a warning about a potential failure of the energy storage device in response to determining that the measurements from at least one sensor pad indicates a deformation in the energy storage device that causes a compression of the substrate layer to move the exterior surface closer to the at least one sensor pad than the nominal distance.

Example 2: The system of example 1, wherein the processor is further operable with the sensor circuit to: compare, over time, the measurements output to the signal layer; determine, based on the measurements output over time, whether any of the sensor pads is closer to the exterior surface than the nominal distance maintained by the substrate layer.

Example 3: The system of example 1 or 2, wherein the deformation is caused by swelling or enlargement of the energy storage device that results in a variable distance or an air gap within the multiple layers that is between an outer layer of the sensor circuit nearest the exterior surface and the at least one sensor pad.

Example 4: The system of any preceding example, wherein the multiple layers further include a cap layer arranged between the substrate layer and the exterior surface, the cap layer comprises a rigid material that is allowed to flex due to the compression to allow the exterior surface to move closer to the at least one sensor pad than the nominal distance maintained by the substrate prior to the compression.

Example 5: The system of example 4, wherein the embedded sensors are affixed to an opposite side of the cap layer from a side of the cap layer adjacent to the exterior surface of the energy storage device.

Example 6: The system of any preceding example, wherein the compression causes a variation in the measurements from the at least one sensor pad relative to the measurements output prior to the compression.

Example 7: The system of any preceding example, wherein the embedded sensors comprise multiple capacitive sensors or multiple inductive sensors.

Example 8: The system of any preceding example, wherein the embedded sensors comprise multiple pressure sensors.

Example 9: The system of any preceding example, wherein the embedded sensors are arranged in at least one of a horizontal array, a vertical array, or a combination of the horizontal array and the vertical array to obtain the measurements from the sensor pads being located at different positions along a horizontal axis or a vertical axis of the exterior surface.

Example 10: The system of any preceding example, wherein the compression of the substrate layer occurs at a cavity region within the multiple layers, and each of the embedded sensors is associated with a different cavity region within the multiple layers.

Example 11: The system of any preceding example, wherein the processors is configured to determine whether the measurements indicate that any of the sensor pads is closer to the exterior surface than the nominal distance maintained by the substrate layer from using a machine-learned model to identify the deformation based on capacitance values or inductance values included in the measurements.

Example 12: The system of any preceding example, wherein the processor is configured to: in response to detecting a vibration event, ignore the measurements for a cycle, the vibration event being detected using an inertial measurement unit of the system or the vehicle.

Example 13: A method comprising: detecting, by a processor on a vehicle, an energy storage device for supplying on-board energy to power a vehicle load; obtaining, from a sensor circuit on the vehicle, sensor data indicating changes in size to an exterior of the energy storage device; determining, based on the sensor data, whether the changes in the size indicate physical deformation of the energy storage device; and in response to determining that the sensor data indicates a deformation of the energy storage device, outputting an alert to terminate or request approval prior to continuing vehicle operations with the energy storage device.

Example 14: The method of example 13, wherein the sensor data comprises capacitance values obtained from capacitive sensors of the sensor circuit, and determining whether the changes in the size indicate the physical deformation includes determining whether the capacitance values indicate the physical deformation.

Example 15: The method of example 14, wherein determining whether the capacitance values indicate the physical deformation includes at least one of: determining an average of the capacitance values is greater than a previous average of capacitance values or a threshold average value; determining a standard deviation of the capacitance values is greater than a previous standard deviation of capacitance values or a threshold standard deviation value; or determining at least one of the capacitance values is above a threshold value.

Example 16: The method of any preceding example, wherein determining whether the changes in the size indicate the physical deformation comprises using a machine-learned model to identify the physical deformation based on capacitance values or inductance values in the sensor data.

Example 17: The method of any preceding example, wherein the method further comprises: in response to a cycle time expiring, obtaining new sensor data; and determining, based on the new sensor data, whether new changes in the size indicate the physical deformation.

Example 18: The method of any preceding example, wherein the method further comprises: determining an identification of the energy storage device; and retrieving a saved profile or a default profile associated with the identification of the energy storage device, wherein determining whether the changes in the size indicate the physical deformation comprises comparing the sensor data to the saved profile or the default profile.

Example 19: The method of any preceding example, wherein the energy storage device comprises a vehicle battery or battery pack comprising multiple cells or pouches.

Example 20: A non-transitory computer-readable medium that stores computer-executable instructions and, when executed by a processor for a vehicle, cause the processor to perform the method of any preceding example.

Example 21: A system for a vehicle, the system comprising means for performing the method of any preceding example.

### CONCLUSION

While various embodiments of the disclosure are described in the foregoing description and shown in the drawings, it is to be understood that this disclosure is not limited thereto but may be variously embodied to practice within the scope of the following claims. From the foregoing description, it will be apparent that various changes may be made without departing from the scope of the disclosure as defined by the following claims.

## Claims

1. A method comprising:
detecting, by a processor on a vehicle, an energy storage device for supplying on-board energy to power a vehicle load;
obtaining, from a sensor circuit on the vehicle, sensor data indicating changes in size to an exterior of the energy storage device;
determining, based on the sensor data, whether the changes in the size indicate physical deformation of the energy storage device; and
in response to determining that the sensor data indicates a deformation of the energy storage device, outputting an alert to terminate or request approval prior to continuing vehicle operations with the energy storage device.

2. The method of claim 1, wherein the sensor data comprises capacitance values obtained from capacitive sensors of the sensor circuit, and determining whether the changes in the size indicate the physical deformation includes determining whether the capacitance values indicate the physical deformation.

3. The method of claim 2, wherein determining whether the capacitance values indicate the physical deformation includes at least one of:
determining an average of the capacitance values is greater than a previous average of capacitance values or a threshold average value;
determining a standard deviation of the capacitance values is greater than a previous standard deviation of capacitance values or a threshold standard deviation value; or
determining at least one of the capacitance values is above a threshold value.

4. The method of any of claims 1-3, wherein determining whether the changes in the size indicate the physical deformation comprises using a machine-learned model to identify the physical deformation based on capacitance values or inductance values in the sensor data.

5. The method of any of claims 1-4, wherein the method further comprises:
in response to a cycle time expiring, obtaining new sensor data; and
determining, based on the new sensor data, whether new changes in the size indicate the physical deformation.

6. The method of any of claims 1-5, wherein the method further comprises:
determining an identification of the energy storage device; and
retrieving a saved profile or a default profile associated with the identification of the energy storage device,
wherein determining whether the changes in the size indicate the physical deformation comprises comparing the sensor data to the saved profile or the default profile.

7. The method of any of claims 1-6, wherein the energy storage device comprises a vehicle battery or battery pack comprising multiple cells or pouches.

8. The method of any of claims 1-7, further comprising:
comparing, over time, the measurements output to the signal layer;
determining, based on the measurements output over time, whether any of the sensor pads is closer to the exterior surface than the nominal distance maintained by the substrate layer.

9. The method of any of claims 1-8, wherein the deformation is caused by swelling or enlargement of the energy storage device that results in a variable distance or an air gap within the multiple layers that is between an outer layer of the sensor circuit nearest the exterior surface and the at least one sensor pad.

10. The method of any of claims 1-9, wherein the multiple layers further include a cap layer arranged between the substrate layer and the exterior surface, the cap layer comprises a rigid material that is allowed to flex due to the compression to allow the exterior surface to move closer to the at least one sensor pad than the nominal distance maintained by the substrate prior to the compression.

11. The method of claim 10, wherein the embedded sensors are affixed to an opposite side of the cap layer from a side of the cap layer adjacent to the exterior surface of the energy storage device.

12. The method of any of claims 1-11, further comprising at least one of:
determining whether the measurements indicate that any of the sensor pads is closer to the exterior surface than the nominal distance maintained by the substrate layer from using a machine-learned model to identify the deformation based on capacitance values or inductance values included in the measurements; or.
in response to detecting a vibration event, ignoring the measurements for a cycle, the vibration event being detected using an inertial measurement unit of the system or the vehicle.

13. A system comprising:
a sensor circuit for monitoring health of an energy storage device installed in a vehicle, the sensor circuit comprising multiple layers of stacked material arranged fixed near an exterior surface of the energy storage device, the multiple layers including:
at least one sensor layer to support individual sensor pads for a plurality of embedded sensors;
at least one substrate layer to isolate and maintain the individual sensor pads supported by the sensor layer at a nominal distance from the exterior surface;
at least one signal layer operatively coupled to the individual sensor pads to output measurements from the sensor pad of each of the embedded sensors; and
at least one processor operable with the sensor circuit to:
determine, based on the measurements, whether any of the sensor pads is closer to the exterior surface than the nominal distance maintained by the substrate layer; and
output a warning about a potential failure of the energy storage device in response to determining that the measurements from at least one sensor pad indicates a deformation in the energy storage device that causes a compression of the substrate layer to move the exterior surface closer to the at least one sensor pad than the nominal distance.

14. The system of claim 13, wherein the sensor circuit is configured to perform the method of any of claims 1-12.

15. A non-transitory computer-readable medium that stores computer-executable instructions and, when executed by a processor for a vehicle, cause the processor to perform the method of any of claims 1-12.
